(19) Europäisches Patentamt
European Patent Office
Office européen des brevets

(11) **EP 3 579 010 B1**

(12) **EUROPÄISCHE PATENTSCHRIFT**

(45) Veröffentlichungstag und Bekanntmachung des Hinweises auf die Patenterteilung:
**28.07.2021   Patentblatt 2021/30**

(51) Int Cl.:
**G01R 33/50** *(2006.01)*     **G01R 33/56** *(2006.01)*
**G01R 33/48** *(2006.01)*

(21) Anmeldenummer: **18176587.6**

(22) Anmeldetag: **07.06.2018**

(54) **VERBESSERTE BESTIMMUNG VON QUANTITATIVEN GEWEBEPARAMETERN**

IMPROVED DETERMINATION OF QUANTITATIVE TISSUE PARAMETERS

DÉTERMINATION AMÉLIORÉE DE PARAMÈTRES TISSULAIRES QUANTITATIFS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**11.12.2019   Patentblatt 2019/50**

(73) Patentinhaber: **Siemens Healthcare GmbH**
**91052 Erlangen (DE)**

(72) Erfinder: **Nickel, Marcel Dominik**
**91074 Herzogenaurach (DE)**

(56) Entgegenhaltungen:
**DE-A1-102014 214 828     US-A1- 2016 349 341**

- **B. MARTY ET AL: "Fast, precise, and accurate myocardial T 1 mapping using a radial MOLLI sequence with FLASH readout : Myocardial T 1 Mapping Using a Radial MOLLI Sequence With FLASH Readout", MAGNETIC RESONANCE IN MEDICINE., Bd. 79, Nr. 3, 3. Juli 2017 (2017-07-03), Seiten 1387-1398, XP055529306, US ISSN: 0740-3194, DOI: 10.1002/mrm.26795**
- **SEIBERLICH N. ET AL.: "Average Correlation Orthogonal Matching Pursuit for Improved Relaxation Parameter Estimation", PROCEEDINGS OF THE INTERNATIONAL SOCIETY FOR MAGNETIC RESONANCE IN MEDICINE, 19TH ANNUAL MEETING & EXHIBITION, 7. Mai 2011 (2011-05-07), Seite 2742, XP040619501, Canada**
- **DONEVA M.: "Dictionary & Model-Based Methods", PROCEEDINGS OF THE INTERNATIONAL SOCIETY FOR MAGNETIC RESONANCE IN MEDICINE, 25TH ANNUAL MEETING & EXHIBITION, Nr. 8110, 7. April 2017 (2017-04-07), XP040693472, USA**

EP 3 579 010 B1

**Beschreibung**

Die vorliegende Erfindung betrifft ein Verfahren zur quantitativen ortsaufgelösten Bestimmung von einem physiologischen Gewebeparameter eines Untersuchungsobjekts und die zugehörige MR-Anlage hierfür. Weiterhin ist ein Computerprogrammprodukt mit Programmmitteln und ein elektronisch lesbarer Datenträger vorgesehen.

MR-Bilder weisen in der klinischen Bildgebung meist einen relativen Kontrast auf, wobei die exakten Pixelwerte vielen Einflüssen unterliegen, wie beispielsweise den für die Messung gewählten Parametereinstellung. Weitere Einflussfaktoren sind beispielsweise Spulensensitivitäten und die verwendete Feldstärke etc.

Bei vielen Anwendungen ist es wünschenswert, ein quantitatives MR-Bild zu erzeugen, bei dem physiologische Gewebeparameter wie beispielsweise eine T1 Zeit oder andere physiologische Parameter bei der Gabe von Kontrastmittel wie die Ankunftszeit des Kontrastmittels, quantitativ ortsaufgelöst vorliegen.

Diese Parameterkarten werden oft aus konventionellen Akquisitionen gefittet, indem ein Signalmodell angenommen wird, dessen Parameter in den zu Grunde liegenden aufgenommenen MR-Bildern variieren. Sind genügend MR-Daten akquiriert worden mit verschiedenen Parameterwerten, lassen sich die Parameter über fitten bestimmen. In der Regel wird in solchen Fällen für jeden Bildpunkt oder jedes Voxel separat gefittet. Eine Möglichkeit hierfür ist die Suche nach der Lösung mit der Methode der kleinsten Quadrate. Wenn sich das zugehörige Problem nicht oder nur zum Teil analytisch lösen lässt, können auch numerische Optimierer verwendet werden wie beispielsweise der Marquardt-Levenberg oder Nelder-Mead Algorithmus.

Diese Verfahren sind zeitlich teilweise sehr aufwendig und haben den Nachteil, dass nicht immer der optimale Parameterwert gefunden wird, sondern eventuell nur ein lokales Minimum und nicht das globale Minimum.

Weiterhin ist eine Technologie Magnetic Resonance Fingerprinting, MRF, bekannt, mit der quantitative Parameterkarten erzeugt werden können. Bei dieser Technologie wird üblicherweise mit einer Spiraltrajektorie der Rohdatenraum sehr schnell abgetastet wobei mittels variierendem Parametern wie die Echozeit oder die Repetitionszeit ein Gleichgewichtszustand vermieden wird und eine möglichst hohe Dynamik erzeugt wird. Aus einer Reihe von simulierten Signalverläufen mit variierenden Eingangsparametern werden dann die Signalverläufe ausgewählt, die den Signalverläufen in den einzelnen Bildpunkten am ähnlichsten sind. Mit der Wahl des Zeitverlaufs und damit der Eingangsparameter sind auch die physiologischen Parameter bestimmt. Bei diesem Verfahren werden jedoch nicht klinisch verwertbare MR-Bilder aufgenommen, und üblicherweise werden mehrere hundert stark unterabgetastete MR-Bilder aufgenommen, um aus dem Signalverlauf über die unterschiedlichen Aufnahmen auf die physiologischen Gewebeparameter schließen zu können. Die bei dieser Technik aufgenommenen MR-Aufnahmen sind jedoch klinisch nicht auswertbar. Sie entsprechen keinem definierten Bildkontrast. Stattdessen ist die Annahme, dass Beiträge anderer Bildpunkte inkohärent sind und als Rauschen interpretiert werden können. Die Intensitätsverläufe in einem Bildpunkt werden also als stark verrauschte Signalverläufe der in Echtzeit verlaufenden Messung interpretiert, die an aufwendige Bloch-Simulationen der Messung gefittet werden. Im B. Marty et al. "Fast, precise and accurate myocardial T1 mapping using a radial MOLLI sequence with FLASH readout: Myocardial T 1 Mapping Using a Radial MOLLI Sequence With FLASH Readout" MRM Bd. 79, Nr. 3, Seiten 1387 bis 1398 ist ein Verfahren zur Bestimmung einer T 1 Zeit im Myokard beschrieben.

Die Patentanmeldung US2016/0349341 A1 beschreibt ein Verfahren zur quantitativen ortsaufgelösten Bestimmung von physiologischen Gewebeparametern eines Untersuchungsobjekts mittels "magnetic resonance fingerprinting" unter Verwendung einer erstellten Nachschlagetabelle.

Es ist eine Aufgabe der vorliegenden Erfindung die oben beschriebenen Nachteile zumindest teilweise zu vermindern und ein Verfahren zur quantitativen Bestimmung von physiologischen Gewebeparametern bereitzustellen, das schneller durchführbar ist, wobei bei der Berechnung Optimierungsverfahren nicht nur ein lokales Optimum sondern ein globales Optimum bzw. Minimum gefunden wird.

Diese Aufgabe wird durch die Merkmale der unabhängigen Ansprüche gelöst. Weitere Ausführungsformen sind in den abhängigen Ansprüchen beschrieben.

Gemäß einem ersten Aspekt der Erfindung wird ein Verfahren zur quantitativen ortsaufgelösten Bestimmung von einem physiologischen Gewebeparameter eines Untersuchungsobjekts bereitgestellt, wobei ein Signalmodell bestimmt wird mit m verschiedenen Signalparametern, die ein MR-Signal der Untersuchungsperson beeinflussen. Weiterhin werden N verschiedene MR-Bilder des Untersuchungsobjekts aufgenommen, wobei m <=N ist, wobei aus den N MR-Bildern bildpunktweise Messdatentupel mit N Messwerten bestimmt werden. Weiterhin wird eine Nachschlagetabelle erstellt mit mehreren Tabelleneinträgen, wobei jeder Tabelleneintrag einen m-dimensionalen Tupel von Signalparametern ein N dimensionales Tupel von synthetisierten Messwerten zuordnet, die mit dem Signalmodell berechnet wurden. Anschließend erfolgt ein Vorprozessieren der erstellten Nachschlagetabelle zur Erstellung einer sortierten Nachschlagetabelle, wobei in der sortierten Nachschlagetabelle die Tabelleneinträge derart angeordnet werden, dass die Bestimmung des nach einer gegebenen Metrik nächstgelegenen synthetischen Messwerts in der sortierten Nachschlagetabelle zu einem Messdatentupel mit einer nearest-neighbour Suche möglich ist. Schließlich erfolgt die Bestimmung von zumindest einigen der Signalparameter durch einen Vergleich der pixelweisen Messdatentupel mit den N dimensionalen Tupeln in der sortierten Nachschlagetabelle für zumindest einige der Bildpunkte mit einem Optimierungsverfahren zur Identifikation eines globalen Minimums in der sortierten Nachschlagetabelle.

Bei dem Vergleich der aufgenommenen Messdatentupel mit den berechneten bzw. synthetisierten MR-Signalwerten in der sortierten Nachschlagetabelle wird eine Optimierungsfunktion verwendet die deutlich schneller ein Ergebnis findet als bei herkömmlichen Verfahren. Das zur Bestimmung der Signalparameter notwendige Fitten wird deutlich schneller und es wird genauer durch die vorprozessierte Nachschlagetabelle, bei der die Tabelleneinträge gemäß einem definierten Kriterium sortiert wurden. Weiterhin wird das globale Minimum der Optimierungsfunktion besser und zuverlässiger gefunden als bei Verfahren nach dem Stand der Technik. Dadurch ist es möglich, komplexere physiologische Gewebeparameter zu berechnen wie beispielsweise pharmako-kinetische Modellierungen bei der kontrastverstärkten Perfusion.

Vorzugsweise handelt es sich bei den aufgenommenen N MR-Bildern um MR-Bilder, bei denen der zugehörige Rohdatenraum so aufgeteilt wird, dass die MR-Bilder einen morphologischen vollen Kontrast aufweisen und zur Befundung des Untersuchungsobjekts wendet werden können, beispielsweise bei einer Befundung durch einen Arzt.

Erfindungsgemäß werden in der sortieren Nachfragetabelle die Tabelleneinträge derart angeordnet, dass die Bestimmung des nach einer gegebenen Metrik nächstliegenden synthetischen Messwerts in der sortierten Nachfragetabelle zu einem Messdatentupel mit einem nearest-neighbor Verfahren möglich ist. Hierbei werden durch die Sortierung bei dem nearest-neighbor Verfahren eine Anzahl von Vergleichsschritten verwendet, die in der Größenordnung eines Logarithmus der Anzahl der Einträge in der sortierten Nachschlagetabelle liegt.

N ist hierbei vorzugsweise <100, weiter vorzugsweise <50 oder sogar <10. Dies bedeutet, dass nur eine geringe Anzahl von MR-Bildern aufgenommen werden.

Der Vergleich der pixelweisen Messdatentupel mit den Sätzen der berechneten MR-Signalwerten entspricht einem Optimierungsproblem. Vor der Durchführung des Vergleichs ist es möglich, aus den M verschiedenen Signalparametern mindestens ein Signalparameter analytisch zu eliminieren, so dass die Anzahl der Signalparameter, für die in der Nachschlagetabelle verschiedene Tabelleneinträge vorhanden sind, verringert wird. Das Optimierungsproblem bei dem Vergleich der Messdatentupel mit den Sätzen der berechneten MR-Signalwerten kann mit einer nearest-neighbor Suche, oder einer approximativen nearest-neighbor Suche gelöst werden.

Weiterhin ist es möglich, dass der bestimmte physiologische Gewebeparameter als Ausgangspunkt einer weiteren nichtlinearen Optimierung zur Bestimmung eines verbesserten physiologischen Gewebeparameters verwendet wird. Das Ergebnis des vorliegenden Verfahrens kann damit als Startwert einer nichtlinearen Optimierung verwendet werden, um den berechneten physiologischen Gewebeparameter weiter zu verbessern.

Die Bildpunkte der aufgenommenen MR-Bilder können in Abhängigkeit von einem Gewebeparameter in zumindest zwei unterschiedliche Bildpunktphasen unterteilt werden, wobei für jede Bildpunktklasse eine Nachschlagetabelle erstellt wird. Hier ist es möglich mehrere Nachschlagetabellen zu erzeugen, beispielsweise für Gewebekomponenten die Fett bzw. Wasser enthalten. Wenn nach einer Fett-Wasserseparierung bekannt ist, ob Fett oder Wasser der dominierende Teil ist, so können unterschiedliche Nachschlagetabellen für die unterschiedlichen Gewebearten verwendet werden bei dem Vergleich.

Weiterhin wird gemäss Anspruch 9 eine MR-Anlage bereitgestellt, die ausgebildet ist zur quantitativen ortsaufgelösten Bestimmung des physiologischen Gewebeparameters, wobei die MR-Anlage eine Steuereinheit und eine Sprecheinheit aufweist, wobei die Speichereinheit von der Steuereinheit ausführbare Informationen speichert, und wobei die MR-Anlage ausgebildet ist bei der Ausführung der Steuerinformationen in der Steuereinheit das erfindungsgemässe Verfahren durchzuführen.

Weiterhin wird gemäss Anspruch 10 ein Computerprogrammprodukt bereitgestellt, welches Programmmittel umfasst und direkt in eine Speichereinheit einer Steuereinheit der MR-Anlage ladbar ist, um die Schritte des erfindungsgemässen Verfahrens auszuführen wenn die Programmmittel in der Steuereinheit ausgeführt werden.

Zusätzlich wird gemäss Anspruch 11 ein elektronisch lesbarer Datenträger bereitgestellt mit darauf gespeicherten elektronisch lesbaren Steuerinformationen. Diese sind derart ausgebildet, dass sie bei Verwendung des Datenträgers in einer Steuereinheit der MR-Anlage das erfindungsgemässe Verfahren durchführen.

Die oben dargelegten Merkmale und weitere Merkmale die nachfolgend beschrieben werden, können nicht nur in den entsprechenden explizit dargestellten Kombinationen verwendet werden, sondern auch in weiteren Kombinationen, sofern es nicht explizit anders erwähnt ist und sofern die Kombinationen durch den beanspruchten Schutzumfang abgedeckt sind.

Die Erfindung wird nachfolgend unter Bezugnahme auf die beiliegenden Zeichnungen näher erläutert.

Figur 1 zeigt schematisch eine MR-Anlage mit der erfindungsgemäß quantitative ortsaufgelöste physiologische Gewebeparameter berechnet werden können.

Figur 2 zeigt schematisch wie mit Hilfe von aufgenommenen MR-Bildern am Beispiel einer T1 Zeit aus einem Messdatentupel der physiologische Gewebeparameter bestimmt wird.

Figur 3 zeigt schematisch ein Flussdiagramm mit den Schritten zur quantitativen ortsaufgelösten Bestimmung des philologischen Gewebeparameters.

Nachfolgend wird die vorliegende Erfindung anhand bevorzugter Ausführungsformen unter Bezugnahme auf die beiliegenden Zeichnungen näher erläutert. In den Figuren bezeichnen gleiche Bezugszeichen gleiche oder ähnliche Elemente. Weiterhin sind die Figuren schematische Darstellungen verschiedener Ausführungsformen der Erfindung. In den Figuren dargestellte Elemente sind nicht notwendigerweise maßstabsgetreu dargestellt. Die in den Figuren dargestellten Elemente sind vielmehr derart wiedergegeben, dass ihre Funktion und ihr Zweck für den Fachmann verständlich werden. Die in den Figuren dargestellten Verbindungen zwischen funktionellen Einheiten oder sonstigen Elementen können auch als indirekte Verbindung implementiert werden, wobei eine Verbindung drahtlos oder drahtgebunden erfolgen kann. Funktionelle Einheiten können als Hardware, Software oder eine Kombination aus Hardware und Software implementiert werden.

Bei der Bestimmung der physiologischen Gewebeparameter mit dem Vergleich der aufgenommenen Messdaten Tupel mit den berechneten MR-Signalwerten wird ein Optimierungsverfahren verwendet und einige Optimierungsprobleme lassen sich zumindest teilweise in ein nearest-neighbor Problem umformulieren. Das ist insbesondere für pharmako-kinetische Modellierung der kontrastmittelverstärkten MR-Bildgebung der Fall, kann aber auch bei anderen Verfahren wie die T1 Zeitbestimmung oder bei der Multiecho-Dixon-Technik verwendet werden.

Für das nearest-neighbor Problem gibt es zwei verschiedene Optimierungsmöglichkeiten:

- es lässt sich eine Menge von möglichen Signalen in einem vorgegebenen Parameterraum für die gegebene Akquisition simulieren, der sogenannten Nachschlagetabelle, aus der in einem zweiten Schritt für jedes Voxel das am nächsten gelegene Signal bestimmt wird. Da dieses Vorgehen für sehr viele Bildpunkte oder Voxel wiederholt wird, ist es sinnvoll und möglich, das simulierte Signal, nämlich die erstellte Nachschlagetabelle so vorab zu prozessieren, dass sich die Bestimmung des nächstgelegenen Signals sehr effizient durchführen lässt. Hierbei lässt sich eine Suche nach dem optimalen Wert, die linear mit der Größe der Nachschlagetabelle ist, oft auf eine Komplexität mit dem Logarithmus der Größe zurückführen. Dies ist im eindimensionalen Fall bei einem Signalparameter einfach zu erkennen. Im eindimensionalen Fall kann die Vorporzessierung einer einfachen Sortierung der Größe nach entsprechen. Sucht man nun für ein Messdatentupel den besten Werte in der Nachschlagetabelle, so kann in Abhängigkeit davon, ob das Messdatentupel größer oder kleiner als die berechneten MR-Signalwerte sind, die eine Hälfte des Parameterraums bei der Suche nicht mehr berücksichtigt werden. Damit halbiert sich bei der Suche immer die Größe des Parameterraums, was einem Logarithmus zur Basis 2 entspricht bei der Suche.

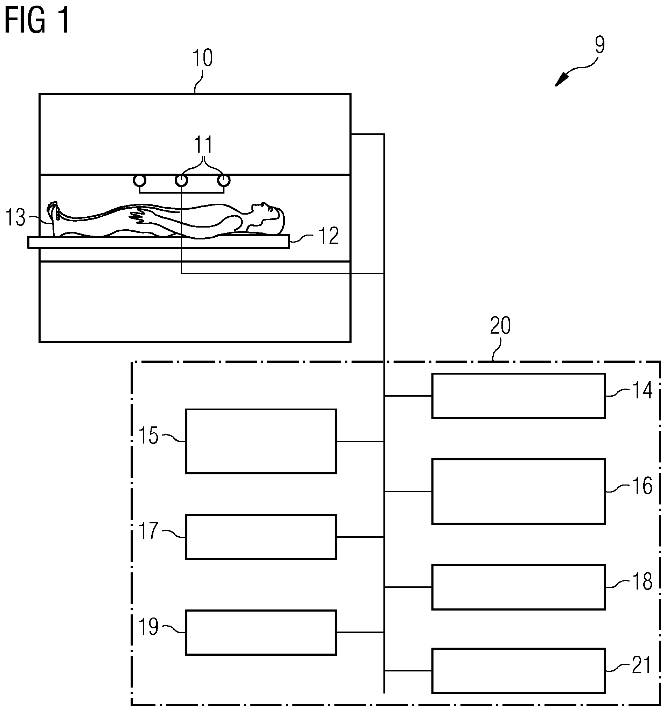

Figur 1 zeigt schematisch eine MR-Anlage mit der, wie nachfolgend erläutert wird, quantitative ortsabhängige physiologische Gewebeparameter schnell berechnet werden können. Die MR-Anlage 9 weist einen Magneten 10 zur Zeugung eines Polarisationsfeldes $B_0$ auf, wobei eine auf einer Liege 12 angeordnete Untersuchungsperson 13 in den Magneten gefahren wird, um dort Magnetresonanzsignale aus der Untersuchungsperson aufzunehmen. Die zur Signalaufnahme verwendeten Spulen 11 repräsentieren die Ganzkörperspule oder die verwendeten Lokalspulen. Durch Einstrahlen von Hochfrequenzpulsen und Schalten von Magnetfeldgradienten kann die durch das Polarisationsfeldes $B_0$ erzeugte Magnetisierung aus der Gleichgewichtslage ausgelenkt und ortskodiert werden, und die sich ergebende Magnetisierung wird von den Empfangsspulen 11 detektiert. Wie durch das Einstrahlen der HF-Pulse und durch Schalten von Magnetfeldgradienten in verschiedenen Kombinationen und Reihenfolgen MR-Bilder erzeugt werden können, ist dem Fachmann bekannt und wird hier nicht näher erläutert.

Die MR-Anlage weist weiterhin eine Steuereinheit 20 auf, die zur Steuerung der MR-Anlage 9 verwendet werden kann. Die Steuereinheit 20 weist eine HF-Steuereinheit 14 auf, eine Gradientensteuereinheit 15 zur Steuerung und Schaltung der Magnetfeldgradienten, wobei die HF-Steuereinheit 14 für die Steuerung und Generierung der HF-Pulse zur Auslenkung der Magnetisierung vorgesehen ist. Eine Bildsequenzsteuerung 16 steuert die Abfolge der Magnetfeldgradienten, der Signaldetektion und der HF-Pulse. Über eine Eingabeeinheit 17 kann eine Bedienperson die MR-Anlage steuern, und auf eine Anzeige 118 können MR-Bilder oder sonstige zur Steuerung notwendige Information angezeigt werden. Eine Recheneinheit 19 mit mindestens einer Prozessoreinheit ist vorgesehen zur Steuerung der verschiedenen Einheiten in der Steuereinheit 20. Weiterhin ist eine Speichereinheit 21 vorgesehen, in der beispielsweise Programmmodule bzw. Programme abgespeichert werden können die, wenn sie von der Recheneinheit 19 ausgeführt werden, den Ablauf der MR-Anlage steuern. Die Recheneinheit 19 kann hierbei wie nachfolgend erläutert wird, derart ausgebildet sein, dass eine quantitative ortsaufgelöst Bestimmung von physiologischen Gewebeparametern möglich ist.

Die parametrische Bildgebung basiert darauf, unterschiedliche Kontraste zu akquirieren und durch Fitten an ein Signalmodell die darunterliegenden Parameter zu extrahieren. Bei den unterschiedlichen Kontrasten handelt es sich um morphologische MR-Bilder bzw. Volumen, die mit mehreren Messparametern aufgenommen wurden. Dies kann durch mehrere einzelne Messungen erfolgen oder simultan in einer Messung.

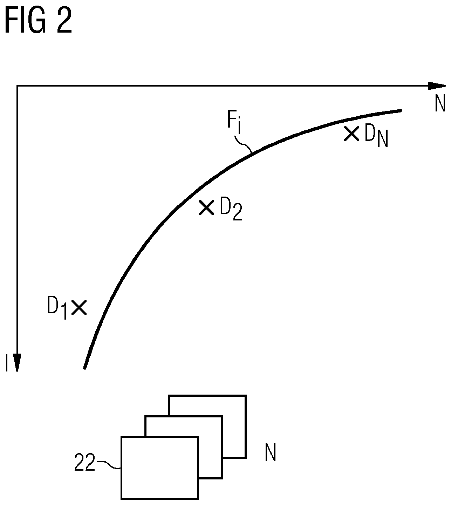

Figur 2 zeigt schematisch die Grundsätze zur Bestimmung eines physiologischen Gewebeparameters, hier der T1 Zeit. Nach einem Inversionspuls, der die Magnetisierung um 180° ausgelenkt, werden zu unterschiedlichen Zeitpunkten der Relaxationskurve MR-Bilder aufgenommen wie beispielsweise die MR-Bilder 22 von Figur 2, im dargestellten Fall drei MR-Bilder. Wenn nun die Signalintensitäten über N bildpunktweise bestimmt werden, so ergeben sich beispielsweise die Signalintensitäten, $D_1$, $D_2$ bis $D_N$. Durch Annahme eines Signalmodells mit unterschiedlichen T1 Zeiten kann dann ein Signalmodell bestimmt werden, das Signalmodell $F_i$. Durch ein Optimierungsproblem kann nun F so bestimmt werden, dass das Signalmodell F möglichst gut die aufgenommenen Messdatenpunkte $D_1$ bis $D_N$ abbildet.

Beispielsweise können in Verbindung mit der Gabe von Kontrastmittel MR-Bilder vor, während und nach der Gabe des Kontrastmittels aufgenommen werden, um so aus dem Signalverlauf den physiologischen Gewebeparameter wie die Ankunftszeit des Kontrastmittels, die sogenannte arrival time TA zu berechnen, den Parameter TTP, time to peak, die Auswaschkurve oder das Integral unter den Intensitätsverlauf zu bestimmen. Als pharmako-kinetische Modelle können diese Modelle die physiologischen Parameter wie $k_{Trans}$, $k_{ep}$ beinhalten. Wie schon in Zusammenhang mit Figur 2 erläutert können bei MR-Bildern mit unterschiedlichen Inversionszeiten die Parameter T1 oder die Protonendichte $M_0$ bestimmt werden. Ebenso kann beispielsweise das Profil des HF-Anregungspuls bestimmt werden. Bei Bildern mit unterschiedlichen T1 oder T2 Wichtungen ist es möglich, die T1 Zeit oder die T2 Zeit ortsaufgelöst zu bestimmen. Bei Bildern mit unterschiedlicher Diffusionswichtung können Modellparameter wie der ADC, apparent diffusion coefficient, die Magnetisierung $M_0$ oder der Perfusionsanteil berechnet werden. Bei der Wasser- Fettseparierung mit multi-Echosequenzen ist es möglich, als Parameter den Wasseranteil, den Fettanteil oder Relaxationszeiten zu berechnen.

Nachfolgenden wird allgemein die Bestimmung des Signalmodells und der anschließende Optimierungsprozess beschrieben. An einem Voxel oder Bildpunkt werden die Kontraste an ein Signalmodell gefittet das typischerweise die folgende Form hat

$$\theta = \underset{\theta}{\arg\min} \ \sum_{i=1}^{N} |D_i(x) - F_i(\theta)|^2, \qquad (1)$$

wobei die dort verwendeten Größen wie folgt definiert sein:

- $\theta$ der Vektor der bestimmten Parameter, z. B. $\theta$ = ($M_0$, $T_1$) oder $\theta$ = (TA, $k_{ep}$, $k_{trans}$)
- $N$ die Zahl der Kontraste, d. h. die Anzahl der aufgenommenen MR-Bilder
- $D_i(x)$ der komplexwertige ite Konstrast an Voxel/Pixel x
- $F_i(\theta)$ der Wert des Signalmodells für Parametereinstellungen des ite Konstrast

Alternativ hierzu kann auch folgende Formel verwendet werden.

$$\theta = \underset{\theta}{\arg\min} \ \sum_{i=1}^{N} (|D_i(x)| - F_i(\theta))^2 \qquad (2)$$

$$\theta = \underset{\theta}{\arg\min} \ \sum_{i=1}^{N} (G\,(D_i(x)) - F_i(\theta))^2 \qquad (3)$$

Bei obiger Gleichung 3 wurden die Kontraste auf eine andere Größe abgebildet, beispielsweise wurden Signalintensitäten bei der kontrastmittelverstärkten Bildgebung in Kontrastmittelkonzentrationen rumgerechnet. Hierzu ist anzumerken, dass N die Zahl der aufgenommenen MR-Bilder größer ist als die Zahl der Modellparameter m.

Das ursprüngliche Fit-Problem kann manchmal vereinfacht werden, indem manche Parameter analytisch eliminiert werden

$$F_i(\theta) = A\,f_i(\phi), \quad \texttt{wobei} \ \theta = (\phi,\ \texttt{A}) \qquad (4)$$

Wobei $\theta$ eindimensional ist, $\phi$ N - eindimensional und A der n-te Parameter ist.

$$\Rightarrow \underset{\theta}{\arg\min} \ \sum_{i=1}^{N} |D_i - F_i(\theta)|^2 \qquad (5)$$

$$= \underset{\phi}{\mathrm{argmin}}\ \underset{A}{\mathrm{argmin}}\ \sum_{i=1}^{N} |D_i - A\, f_i(\phi)|^2 \qquad (6)$$

$$\sum_{i=1}^{N} |D_i - A\, f_i(\phi)|^2 = |A|^2 \sum_{i=1}^{N} |f_i(\phi)|^2 - A \sum_{i=1}^{N} D_i^*\, f_i(\phi)$$
$$+ \sum_{i=1}^{N} |D_i|^2 - A^* \sum_{i=1}^{N} D_i\, f_i(\phi) \qquad (7)$$

$$\Rightarrow A = \frac{\sum_{i=1}^{N} D_i\, f_i^*(\phi)}{\sum_{i=1}^{N} |f_i(\phi)|^2} \qquad (8)$$

Mit der Nenndefinition $e_i(\phi) = \dfrac{f_i(\phi)}{\sqrt{\sum_{i=1}^{N} |f_i(\phi)|^2}}$ findet $\qquad (9)$

man

$$\underset{A}{\min} \sum_{i=1}^{N} |D_i - A\, f_i(\phi)|^2 = \sum_{i=1}^{N} \left| D_i - (\sum_{i=1}^{N} D_j\, e_j^*(\phi)) e_i(\phi) \right|^2$$
$$= \sum_{i=1}^{N} |D_i|^2 - \left| \sum_{i=1}^{N} D_j\, e_j^*(\phi) \right|^2 \qquad (10)$$

Durch weitere Definition von

$$d_i = D_i / \sqrt{\sum_{i=1}^{N} |D_j|^2} \qquad (11)$$

erhält man weiterhin

$$\underset{A}{\min} \sum_{i=1}^{N} |D_i - A\, f_i(\phi)|^2 = \frac{1}{2 \|D\|_2^2} \sum_{i=1}^{N} |d_i - e_i(\phi)|^2 \qquad (12)$$

Aus Gleichung 12 ist zu erkennen, dass die globale Skalierung bei der Suche des Mediums keine Rolle spielt

$$= \underset{\theta}{\mathrm{argmin}}\ \sum_{i=1}^{N} |d_i - e_i((\phi)|^2 \qquad (13)$$

Zusammengefasst lässt sich durch Normierung der Daten unter Signalmodells ein Parameter eliminieren und das verbleibende Problem hat die Form eines least-square Fits.

Bei einem konventionellen herkömmlichen Fitten würden die gewünschten Parameter mit Hilfe eines nichtlinearen Optimierers numerisch bestimmt werden. Hierbei ist die Laufzeit des Fittens jedoch groß, da der Algorithmus für jeden Bildpunkt in 2-D, d.h. beispielsweise für über 100.000 Bildpunkte die Berechnung durchgeführt wird und für jeden Bildpunkt das Signalmodell sehr oft ausgewertet wird, beispielsweise mehr als 100 mal. Diese nichtlinearen Optimierer finden typischerweise nur ein lokales Minimum abhängig von dem Startpunkt. Mehrere Optimierungsschritt mit unterschiedlichen Startpunkten lösen das Problem nur teilweise und erhöhen die Laufzeit insgesamt beträchtlich.

Erfindungsgemäß wird nun ausgenutzt, dass die Optimierung für sehr viele Punkte durchgeführt wird, so dass ein vorangehender Vorprozessionsschritt in der möglichen Nachschlagetabelle akzeptabel ist und nützlich ist. Durch die Vorprozessierung der erstellten Nachschlagetabelle zur Stellung einer sortierten Nachschlagetabelle wird sichergestellt, dass für eine große Menge von Parameterpunkten, beispielsweise mehr als 100.000 Tabelleneinträge mit jeweils einem Satz von berechneten MR-Signalwerten ein Minimum gefunden wird, wodurch das globale Minimum besser sicherstellt.

Für eine bestimmte Klasse von Metriken, die auch l2 und damit ein least-square enthält, ist die Methode der approximate nearest-neighbor Suche möglich. Es wird eine Nachschlagetabelle mit M Elementen des obigen Signalmodells generiert

$$\{(F_1(\theta_m), \dots, F_N(\theta))\}_{m=1,\dots,M} \qquad (14)$$

wobei M über 100.000 sein kann. Danach wird diese Nachschlagetabelle in einer Vorprozessierungsschritt bzw. einer Konfiguration derart aufbereitet, dass bei Vorgabe eines Messdatentupels mit N Werten ($D_1, \dots, D_N$) der nächste Punkt in der Menge, d.h. in der Vorprozessierten Nachschlagetabelle schnell gefunden werden kann im Sinne der Metrik. Durch die Vorsortierung ist dies Approximativ mit $log_2(M)$ vergleichbar. Für $log_2$ **100.000** $< log_2 2^{17} = 17$ ist es möglich in sehr wenigen Schritten den optimierten Wert zu finden. Im eindimensionalen Anfall bei nur einem Signalparameter wird dies verständlich, da bei einer aufsteigenden Anordnung der Werte in der Nachschlagetabelle bei einem Startwert in der Mitte erkannt wird ob der Messdatenwert größer oder kleiner als der Wert in der Nachschlagetabelle ist. Ist er größer, kann die andere Hälfte der Nachschlagetabelle verworfen werden, so dass bei jedem Schritt ungefähr die Hälfte der übriggebliebenen Tabelle verworfen werden kann. Weiterhin muss $F_i(\theta)$ nicht immer neu berechnet werden was für manche Signalmodelle numerisch aufwendig ist, da die Funktion nur bei der Erstellung der Nachschlagetabelle berechnet wird.

Bei einer Anwendung des obengenannten Beispiels mit einem Kontrast und einem Parameter, oder in einem Fall in dem eine Reduktion von Parameter zu einem Parameter führt, entspricht die Vorprozessierung der Sortierung der Größe nach und der Vergleich mit logarithmischer Komplexität einer Intervallschachtelung.

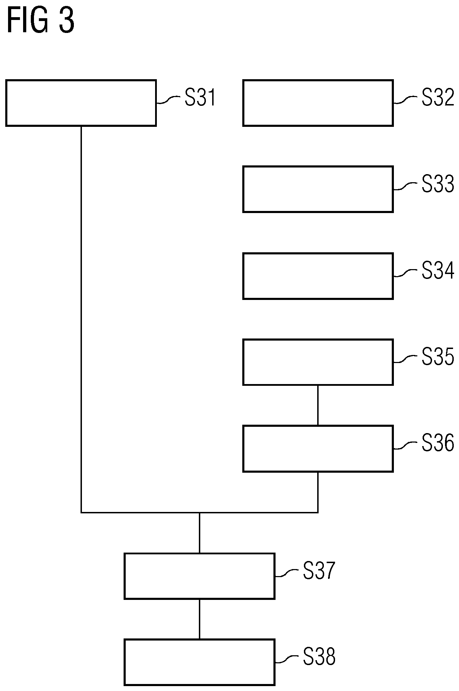

In Zusammenhang mit Figur 3 wird das Verfahren zusammengefasst. In einem Schritt S31 erfolgt die Aufnahme der N verschiedenen MR-Bilder des Untersuchungsobjekts mit N verschiedenen Kontrasten. Ebenso erfolgt in einem Schritt S32 die Wahl des Signalmodells mit den m verschiedenen Signalparametern des MR-Signal der Untersuchungsperson beeinflussen. In einem optionalen Schritt S33 erfolgt die analytische Reduktion von Variablen derart, dass für das neue Problem das Verfahren mit weniger Parametern anwendbar ist.

In einem Schritt S34 folgt schließlich die Wahl der ausgewählten Signalparameter für die die Nachschlagetabelle erzeugt werden soll. Enthält der ausgewählte Signalparameter beispielsweise die T1 Zeit und die Protonendichte $M_0$ so werden diese Parameter jeweils in einem sinnvollen Wertebereich diskretisiert und die verschiedenen Werte werden in das Signalmodell eingesetzt und damit werden für die verschiedenen Kombinationen aus T1 Zeit und Spindichte das Messsignal mit dem Signalmodell berechnet. Dies führt in Schritt S35 zur Erstellung der Nachschlagetabelle. In einem Schritt S36 erfolgt die Vorprozessierung dieser Nachschlagetabelle derart, dass eine sortierte Nachschlagetabelle erzeugt wird, um einen schnellen Vergleich zu ermöglichen. Hierbei erfolgt die Vorprozessierung derart, dass die Bestimmung des nach einer gegebenen Metrik nächstliegenden synthetischen Messdatenpunkts in der sortierten Nachschlagetabelle zu einem gegebenen Messdatenpunkt näherungswiese mit wenigen Vergleichen möglich ist. Mögliche Beispiele für die Vorprozessierung sind folgende Verfahren die näher im Detail beschrieben sind in:

- kd-trees [J. L. Bentley. K-d trees for semidynamic point sets. In Proc. 6th Ann. ACM Sympos. Comput. Geom., pages 187-197, 1990.; J. H. Friedman, J. L. Bentley, and R. A. Finkel. An algorithm for finding best matches in logarithmic expected time. ACM Transactions on Mathematical Software, 3(3):209-226, 1977.]
- box-decomposition [S. Arya, D. M. Mount, N. S. Netanyahu, R. Silverman, and A. Wu. An optimal algorithm for approximate nearest searching. J. ACM, 45:891-923, 1998.]
- tree-ordered search [S. Arya and D. M. Mount. Algorithms for fast vector quantization. In J. A. Storer and M. Cohn, editors, Proc. of DCC '93: Data Compression Conference, pages 381-390.IEEE Press, 1993]
- priority search [S. Arya, D. M. Mount, N. S. Netanyahu, R. Silverman, and A. Wu. An optimal algorithm for approximate nearest neighbor searching. J. ACM, 45:891-923, 1998.]
- J. Kleinberg. Two algorithms for nearest-neighbor search in high dimension. In Proc. 29th Annu. ACM Sympos. Theory Comput., pages 599-608, 1997.
- Marius Muja and David G. Lowe: "Scalable Nearest Neighbor Algorithms for High Dimensional Data". Pattern Analysis and Machine Intelligence (PAMI), Vol. 36, 2014.
- Marius Muja and David G. Lowe: "Fast Matching of Binary Features". Conference on Computer and Robot Vision (CRV) 2012.
- [Marius Muja and David G. Lowe, "Fast Approximate Nearest Neighbors with Automatic Algorithm Configuration", in International Conference on Computer Vision Theory and Applications (VISAPP'09), 2009]

Hierbei ist es wünschenswert, dass die verwendeten Verfahren mit der 12 und 11 Norm funktionieren.

In einem Schritt S37 erfolgt die Bestimmung, vorzugsweise eine approximative Bestimmung der optimalen Signalmodellparameter im Sinne einer Metrik oder Norm für eine Menge von Bildpunkten, wobei dies nicht für alle Bildpunkte des auf genommenen MR-Bilds erfolgen muss. Die Menge der Bildpunkte kann mit einer Maskierung oder Segmentierung vorher ausgewählt werden.

Optional ist es möglich in einem Schritt S38 die aus Schritt S37 berechneten Werte als Startpunkt für eine nichtlineare Optimierung zu verwenden.

Weiterhin ist es möglich, mehrere separate Nachschlagetabellen aufzustellen und für unterschiedliche Bildpunkte zu verwenden, beispielsweise zu einer quantitativen Fett- Wasserseparierung, bei der, wenn für den Bildpunkt bekannt ist und ob er Fett und Wasser dominant enthält, für die Fettbildpunkte eine andere Nachschlagetabelle erzeugt wird als für die Wasserbildpunkte, da die Signalmodelle verschieden ist.

Insgesamt liefert das oben beschriebene Verfahren eine verbesserte quantitative ortsaufgelöst Bestimmung von physiologischen Gewebeparametern. Die erzeugten Parameterkarten enthalten weniger Artefakte da nicht nur das lokale Minimum gefunden wird, die Verarbeitungszeit wird deutlich verringert gegenüber herkömmlichen Verfahren.

Beispiele der konkreten Anwendung sind:

a) Pharmakokinetische Modellierungen von kontrastverstärkten dynamischen Messungen. Hier wird die Signalintensität zunächst in Kontrastmittelkonzentrationen übersetzt und diese an ein Pefusionsmodell gefittet. Die Auswertung des Signalmodells kann relative aufwendig sein, da eine Faltung mit einer arteriellen Inputfunktion durchgeführt werden muss. Weiterhin kann die Zahl der Zeitpunkte mit bis zu 100 für konventionelle parametrische Bildgebung relative hoch sein. Letzteres führt zu einem Optimierungsproblem das leichter lokale Minima enthält und numerisch auch aufwendiger ist.

b) T1- Bestimmung durch Variation von Kippwinkeln in mehreren Gradientenecho- Messungen. Hier ist Anzahl der verschiedenen Kontraste relative gering (typischerweise < 6). Daher können statt approximativen auch exakte nearest-neighbor-Suchen verwendet werden. Prozessierungsdauer ist weniger relevant als die Garantie das globale Minimum zu finden. Das Ergebnis der Suche kann auch als Startpunkt für eine weitere Optimierung verwendet werden.

c) Fett- Wasser und R2*-Bestimmung in multi-echo Gradientenecho- Messungen. Hier ist Anzahl der verschiedenen Kontraste relative gering (typischerweise < 8). Daher können statt approximativen auch exakte nearest-neighbor-Suchen verwendet werden. Prozessierungsdauer ist weniger relevant als die Garantie das globale Minimum zu finden. Das Ergebnis der Suche kann auch als Startpunkt für eine weitere Optimierung verwendet werden. Es ist möglich zwei Nachschlagetabellen für Fett- und Wasser-dominierte Bildpunkte zu definieren.

d) T1- oder T2- Bestimmung durch Abtastung einer Relaxationskurve. Hier ist Anzahl der verschiedenen Kontraste moderat (typischerweise < 20). Daher sind approximative nearest-neighbor-Suchen zu bevorzugen. Prozessierungsdauer ist weniger relevant als die Garantie das globale Minimum (approximativ) zu finden. Das Ergebnis der Suche kann auch als Startpunkt für eine weitere Optimierung verwendet werden.

e) IVIM oder DKI Auswertung von Diffusionsmessungen mit unterschiedlicher Diffusionswichtung. Hier ist Anzahl der verschiedenen Kontraste moderat (typischerweise < 20). Daher sind approximative nearest-neighbor-Suchen zu bevorzugen. Prozessierungsdauer ist weniger relevant als die Garantie das globale Minimum (approximativ) zu finden. Das Ergebnis der Suche kann auch als Startpunkt für eine weitere Optimierung verwendet werden.

## Patentansprüche

1. Verfahren zur quantitativen ortsaufgelösten Bestimmung von einem physiologischen Gewebeparameter eines Untersuchungsobjekts, mit den folgenden Schritten:

   - Bestimmen eines Signalmodells mit m verschiedenen Signalparametern, die ein MR-Signal der Untersuchungsperson beeinflussen,
   - Aufnehmen von N verschiedenen MR-Bildern des Untersuchungsobjekts mit m<=N, wobei aus den N MR-Bildern bildpunktweise Messdatentupel mit N Messwerten bestimmt werden, wobei die N MR-Bilder mit unterschiedlichen Kontrasten aufgenommen werden,
   - Erstellen einer Nachschlagetabelle mit mehreren Tabelleneinträgen, wobei jeder Eintrag einem m-dimensionalen Tupel von Signalparametern ein N-dimensionales Tupel von synthetisierten Messwerten zuordnet, die mit dem Signalmodell berechnet wurden
   - Vorprozessieren der erstellten Nachschlagetabelle zur Erstellung einer sortierten Nachschlagetabelle, wobei in der sortieren Nachschlagetabelle die Tabelleneinträge derart angeordnet werden, dass die Bestimmung des nach einer gegebenen Metrik nächstgelegenen synthetischen Messwertes in der sortierten Nachschlagetabelle zu einem Messdatentupel mit einer nearest-neighbour Suche möglich ist,
   - Bestimmen von zumindest einigen der Signalparameter durch einen Vergleich der bildpunktweisen Messdatentupel mit N dimensionalen Tupeln der synthetisierten Messwerte in der sortierten Nachschlagetabelle für zumindest einige der Bildpunkte mit einem Optimierungsverfahren zur Identifikation eines globalen Minimums in der sortierten Nachschlagetabelle.

2. Verfahren nach Anspruch 1, **dadurch gekennzeichnet, dass** bei dem Aufnehmen der N MR-Bilder der zugehörige Rohdatenraum jeweils so abgetastet wird, dass die MR-Bilder einen morphologisch sinnvollen Kontrast aufweisen und zur Befundung der Untersuchungsobjekts verwendet werden können.

3.  Verfahren nach Anspruch 1 oder 2, N kleiner 100, vorzugsweise kleiner 50 und weiter vorzugswiese kleiner gleich 10 ist.

4.  Verfahren nach Anspruch 1, **dadurch gekennzeichnet, dass** bei der nearest-neighbour Suche eine Anzahl von Vergleichsschritten verwendet wird, die in der Größenordnung eines Logarithmus der Anzahl der Einträge in der sortierten Nachschlagetabelle liegt.

5.  Verfahren nach einem der vorstehenden Ansprüche, **dadurch gekennzeichnet, dass** aus den m verschiedenen Signalparametern zumindest ein Signalparameter analytisch eliminiert wurde und die Anzahl der in der Nachschlagetabelle enthaltenen Signalparametern kleiner m ist, bevor zumindest einige der Signalparameter bestimmt werden durch den Vergleich.

6.  Verfahren nach einem der vorstehenden Ansprüche, **dadurch gekennzeichnet, dass** bei dem Bestimmen des physiologischen Gewebeparameters eine approximatives nearest-neighbor Suche verwendet wird.

7.  Verfahren nach einem der vorstehenden Ansprüche, **dadurch gekennzeichnet, dass** der bestimmte physiologische Gewebeparameter als Ausgangpunkt einer nichtlinearen Optimierung zur Bestimmung eines verbesserten physiologischen Gewebeparameters verwendet wird.

8.  Verfahren nach einem der vorstehenden Ansprüche, **dadurch gekennzeichnet, dass** die Bildunkte der aufgenommen MR-Bilder in Abhängigkeit von einem Gewebeparameter in zumindest 2 unterschiedliche Bildpunktklassen unterteilt werden, wobei für jede Bildpunktklasse eine Nachschlagetabelle erstellt wird.

9.  MR Anlage, die ausgebildet ist zur quantitativen ortsaufgelösten Bestimmung von einem physiologischen Gewebeparameter eines Untersuchungsobjekts, wobei die MR-Anlage eine Steuereinheit und eine Speichereinheit aufweist, wobei die Speichereinheit von der Steuereinheit ausführbare Steuerinformationen speichert, wobei die MR-Anlage ausgebildet ist, bei Ausführung der Steuerinformationen in der Steuereinheit ein Verfahren auszuführen nach einem der vorstehenden Ansprüche.

10. Computerprogrammprodukt, welches Programmmittel umfasst und direkt in eine Speichereinheit einer programmierbaren Steuereinheit einer MR-Anlage ladbar ist, um alle Schritte des Verfahrens nach einem der Ansprüche 1-8 auszuführen, wenn die Programmmittel in der Steuereinheit ausgeführt werden.

11. Elektronisch lesbarer Datenträger mit darauf gespeicherten elektronisch lesbaren Steuerinformationen, welche derart ausgestaltet sind, dass sie bei Verwendung des Datenträgers in einer Steuereinheit einer MR-Anlage das Verfahren nach einem der Ansprüche 1-8 durchführen.


## Claims

1.  Method for the quantitative spatially resolved determination of a physiological tissue parameter of an examination subject, comprising the following steps:

    - determination of a signal model with m different signal parameters, which influence an MR signal of the examination subject,
    - recording of N different MR images of the examination subject with m<=N, wherein measured data tuples with N measured values are determined from the N MR images on a pixel-by-pixel basis, wherein the N MR images are recorded with different contrasts,
    - creating a lookup table with a plurality of table entries, wherein each entry assigns an N-dimensional tuple of synthesised measured values to an m-dimensional tuple of signal parameters that have been calculated using the signal model,
    - pre-processing of the table that has been created in order to create a sorted lookup table, wherein, in the sorted lookup table, the table entries are arranged such that the determination of the synthetic measurement value which, according to a given metric, is nearest in the sorted lookup table to a measured data tuple, is possible with a nearest-neighbour search,

- determination of at least some of the signal parameters by comparing the pixel-by-pixel measured data tuples with N-dimensional tuples of the synthesised measured values in the sorted lookup table for at least some of the pixels with an optimisation method for identifying a global minimum in the sorted lookup table.

2. Method according to claim 1, **characterised in that**, in the recording of the N MR images, the respective raw data space is sampled in each case such that the MR images have a morphological meaningful contrast and can be used for diagnosing the examination subject.

3. Method according to claim 1 or 2, **characterised in that** N is less than 100, preferably less than 50 and furthermore preferably less than or equal to 10.

4. Method according to claim 1, **characterised in that** in the nearest-neighbour search, a number of comparison steps is used, which number is of the order of magnitude of a logarithm of the number of entries in the sorted lookup table.

5. Method according to one of the preceding claims, **characterised in that** at least one signal parameter has been eliminated analytically from the m different signal parameters and the number of the signal parameters contained in the lookup table is less than m, before at least some of the signal parameters are determined by the comparison.

6. Method according to one of the preceding claims, **characterised in that**, in the determination of the physiological tissue parameter, an approximate nearest-neighbour search is used.

7. Method according to one of the preceding claims, **characterised in that** the physiological tissue parameter that has been determined is used as the starting point of a nonlinear optimisation to determine an improved physiological tissue parameter.

8. Method according to one of the preceding claims, **characterised in that** the pixels in the recorded MR images are subdivided as a function of a tissue parameter into at least 2 different pixel classes, with a lookup table being created for each pixel class.

9. MR facility, which is embodied for the quantitative spatially resolved determination of a physiological tissue parameter of an examination subject, wherein the MR facility comprises a control unit and a memory unit, wherein the memory unit stores control data that can be run by the control unit, wherein the MR facility is embodied to carry out a method according to one of the preceding claims when the control data is run in the control unit.

10. Computer program product, which includes programming means and which is directly loadable into a memory unit of a programmable control unit of an MR facility, in order to carry out all the steps in the method according to one of claims 1-8 when the programming means is run in the control unit.

11. Electronically readable data carrier with electronically readable control data stored thereon, which data is embodied such as to carry out the method according to one of claims 1-8 when the data carrier is used in a control unit of the MR facility.

**Revendications**

1. Procédé de détermination quantitative en résolution spatiale d'un paramètre tissulaire physiologique d'un objet à examiner, comprenant les stades suivants :

- la détermination d'un modèle de signal ayant m paramètres différents de signal, qui influencent un signal RM de la personne à examiner,
- l'enregistrement de N images RM différentes de l'objet à examiner avec m<=N, dans lequel on détermine, à partir des N images RM, point d'image par point d'image, des tuples d'unités de mesure par N valeurs de mesure, dans lequel on enregistre les N images RM avec des contrastes différents,
- l'établissement d'une table à consulter ayant plusieurs entrées de table, dans lequel chaque entrée associe à un tuple à m dimensions de paramètres de signal un tuple à N dimensions de valeurs de mesure synthétisées, qui ont été calculées par le modèle de signal,
- le pré-traitement de la table à consulter, qui a été établie, pour l'établissement d'une table à consulter triée, dans lequel on met dans la table à consulter triée les entrées de table de manière à ce que la détermination de la valeur de mesure synthétique, immédiatement suivante dans une métrique donnée, dans la table à consulter triée, en un tuple de données de mesure soit possible par une recherche nearest-neighbour,
- la détermination d'au moins certains des paramètres de signal par une comparaison des tuples de données de mesure, point d'image par point d'image, à des tuples à N dimensions des valeurs de mesures synthétisées dans la table à consulter triée pour au moins certains des points d'image par un procédé d'optimisation pour l'identification d'un minimum global dans la table à consulter triée.

2. Procédé suivant la revendication 1, **caractérisé en ce que**, dans l'enregistrement des N images RM, on échantillonne l'espace de données brutes associé de manière à ce que les images RM aient un contraste significatif, morphologiquement, et puisse être utilisé pour la constatation sur l'objet à examiner.

3. Procédé suivant la revendication 1 ou 2, N étant plus petit que 100, de préférence plus petit que 50, et, de manière encore plus préférée, inférieur ou égal à 10.

4. Procédé suivant la revendication 1, **caractérisé en ce que** dans la recherche nearest-neighbour, on utilise un nombre de stades de comparaison, qui est de l'ordre de grandeur d'un logarithme du nombre des entrées dans la table à consulter triée.

5. Procédé suivant l'une des revendications précédentes, **caractérisé en ce que**, à partir des m paramètres différents de signal, au moins un paramètre de signal a été éliminé analytiquement et le nombre des paramètres de signal contenus dans la table à consulter est plus petit que m, avant qu'au moins certains des paramètres de signal soient déterminés par la comparaison.

6. Procédé suivant l'une des revendications précédentes, **caractérisé en ce que**, lors de la détermination du paramètre tissulaire physiologique, on utilise une recherche nearest-neighbour approximative.

7. Procédé suivant l'une des revendications précédentes, **caractérisé en ce que** l'on utilise le paramètre tissulaire physiologique déterminé comme point de départ d'une optimisation non linéaire pour la détermination d'un paramètre tissulaire physiologique amélioré.

8. Procédé suivant l'une des revendications précédentes, **caractérisé en ce que** l'on subdivise les points d'images des images RM enregistrées en fonction d'un paramètre tissulaire en au moins deux classes de points d'images différentes, une table à consulter étant établie pour chaque classe de points d'image.

9. Installation RM, qui est constituée pour la détermination quantitative en résolution spatiale d'un paramètre tissulaire physiologique d'un objet à examiner, dans laquelle l'installation RM a une unité de commande et une unité de mémoire, dans laquelle l'unité de mémoire met en mémoire des informations de commande pouvant être réalisées par l'unité de commande, dans laquelle l'installation RM est constituée pour, lorsque les informations de commande sont exécutées dans l'unité de commande, effectuer un procédé suivant l'une des revendications précédentes.

10. Produit de programme d'ordinateur, qui comprend des moyens de programme et qui peut être chargé directement dans une unité de mémoire d'une unité de commande programmable d'une installation RM pour effectuer tous les stades du procédé suivant l'une des revendications 1 à 8, lorsque les moyens de programme sont exécutés dans l'unité de commande.

11. Support de données déchiffrables électroniquement sur lequel sont mises en mémoire des informations de commande déchiffrables électroniquement, qui sont conformées de manière à ce qu'elles effectuent, lorsque le support de données est utilisé dans une unité de mémoire d'une installation RM, le procédé suivant l'une des revendications 1 à 8.

FIG 1

# FIG 2

FIG 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20160349341 A1

**In der Beschreibung aufgeführte Nicht-Patentliteratur**

- **B. MARTY et al.** Fast, precise and accurate myocardial T1 mapping using a radial MOLLI sequence with FLASH readout: Myocardial T 1 Mapping Using a Radial MOLLI Sequence With FLASH Readout. *MRM,* vol. 79 (3), 1387-1398
- **J. L. BENTLEY.** K-d trees for semidynamic point sets. *Proc. 6th Ann. ACM Sympos. Comput. Geom.,* 1990, 187-197
- **J. H. FRIEDMAN ; J. L. BENTLEY ; R. A. FINKEL.** An algorithm for finding best matches in logarithmic expected time. *ACM Transactions on Mathematical Software,* 1977, vol. 3 (3), 209-226
- **S. ARYA ; D. M. MOUNT ; N. S. NETANYAHU ; R. SILVERMAN ; A. WU.** An optimal algorithm for approximate nearest searching. *J. ACM,* 1998, vol. 45, 891-923
- Algorithms for fast vector quantization. **S. ARYA ; D. M. MOUNT.** Proc. of DCC '93: Data Compression Conference. IEEE Press, 1993, 381-390
- **S. ARYA ; D. M. MOUNT ; N. S. NETANYAHU ; R. SILVERMAN ; A. WU.** An optimal algorithm for approximate nearest neighbor searching. *J. ACM,* 1998, vol. 45, 891-923
- **J. KLEINBERG.** Two algorithms for nearest-neighbor search in high dimension. *Proc. 29th Annu. ACM Sympos. Theory Comput.,* 1997, 599-608
- **MARIUS MUJA ; DAVID G. LOWE.** Scalable Nearest Neighbor Algorithms for High Dimensional Data. *Pattern Analysis and Machine Intelligence (PAMI),* 2014, vol. 36
- **MARIUS MUJA ; DAVID G. LOWE.** Fast Matching of Binary Features. *Conference on Computer and Robot Vision (CRV),* 2012
- **MARIUS MUJA ; DAVID G. LOWE.** Fast Approximate Nearest Neighbors with Automatic Algorithm Configuration. *International Conference on Computer Vision Theory and Applications (VISAPP'09),* 2009